# EUROPÄISCHE PATENTSCHRIFT

(11) **EP 3 289 842 B1**
(45) Veröffentlichungstag und Bekanntmachung des Hinweises auf die Patenterteilung: **04.11.2020**
(21) Anmeldenummer: 16709779.9
(22) Anmeldetag: 11.03.2016
(51) Int. Cl.: H05K 7/14

(54) **KONTAKTANORDNUNG, VORZUGSWEISE FÜR EINE LEISTUNGSELEKTRONIK**
CONTACT ARRANGEMENT, PREFERABLY FOR A POWER ELECTRONICS SYSTEM
ENSEMBLE DE CONTACTS, DE PRÉFÉRENCE POUR UN DISPOSITIF ÉLECTRONIQUE DE PUISSANCE

(30) Priorität: 30.04.2015 DE 102015208005
(43) Veröffentlichungstag der Anmeldung: 07.03.2018
(73) Patentinhaber: Robert Bosch GmbH, 70442 Stuttgart (DE)
(72) Erfinder: HOU, Qiang, Suzhou Jiangsu 215021 (CN); JIN, Hao, TaiCang City Jiangsu 215433 (CN); WIESA, Thomas, 71665 Vaihingen (DE); MEIER, Andreas, 72793 Pfullingen (DE); CELLO, David, 70178 Stuttgart (DE); SHI, Zhenzhong, Suzhou Jiangsu 215021 (CN); GOEPFERT, Sebastian, 70197 Stuttgart (DE)
(86) Internationale Anmeldenummer: PCT/EP2016/055350
(87) Internationale Veröffentlichungsnummer: WO 2016/173764

(56) Entgegenhaltungen:
- US-A1- 2003 201 120
- US-A1- 2006 094 296
- US-B2- 6 824 399

## Beschreibung

### Stand der Technik

Die vorliegende Erfindung betrifft eine Kontaktanordnung. Die Kontaktanordnung wird insbesondere in einer Leistungselektronik verwendet und dient zum mechanischen Verbinden und elektrisch leitenden Kontaktieren einer Leiterplatte mit einer Basis.

Üblicherweise werden Leiterplatten in Leistungselektroniken mit der entsprechenden Basis (auch: Kontaktstelle oder Gehäuse) direkt verschraubt. Solche Verschraubungen sind nur bedingt tauglich, über die entsprechend hohe Lebensdauer hohe Ströme zu führen. Grund hierfür ist das Setzverhalten des Schraubverbundes durch Kriechen des Leiterplattenbasismaterials und dem daraufhin ansteigenden Übergangswiderstand. Dies führt bei Hochstromanwendungen zu unzulässiger Eigenerwärmung und Ausfall der Verbindung.
Kontaktanordnungen aus dem Stand der Technik sind beispielsweise aus der US 2003/201120 A1, der US 6 824 399 B2 und der US 2006/094296 A1 bekannt.

### Offenbarung der Erfindung

Die erfindungsgemäße Kontaktanordnung ermöglicht eine kraftschlüssige Verbindung der Leiterplatte mit der Basis, die über eine hohe Lebensdauer für eine Stromführung, insbesondere für hohe Ströme, anwendbar ist. Dabei erfolgt eine einfache und zuverlässige Kontaktierung der Leiterplatte zur Abfuhr hoher Ströme unabhängig von den physikalischen Eigenschaften des organischen Materials (Leiterplattenbasismaterial). Hierzu ist erfindungsgemäß eine Kontaktanordnung vorgesehen. Diese umfasst eine Leiterplatte mit einem Befestigungsloch. In das Befestigungsloch ist eine Hülse aus Metall eingesetzt. Die Hülse aus Metall ist mit der Leiterplatte, bzw. mit zumindest einer leitenden Lage der Leiterplatte kontaktiert. Insbesondere ist die Hülse mit der Leiterplatte verlötet. Ferner umfasst die Kontaktanordnung eine Basis, auf der die Hülse zur elektrischen Kontaktierung aufliegt. Durch die Hülse ragt ein Befestigungselement. Ein Ende des Befestigungselementes ist fest mit der Basis verbunden. Am anderen Ende des Befestigungselementes ist ein Kopf ausgebildet oder angeordnet. Wenn das Befestigungselement beispielsweise eine Schraube ist, so ist der Kopf entweder der Schraubenkopf oder eine auf die Schraube aufgeschraubte Mutter. Eine etwaige Unterleg- oder Beilagscheibe zählt im Sinne der Erfindung zum Kopf. Des Weiteren gibt es die Möglichkeit, einen fest in der Basis angeordneten Bolzen als Befestigungselement zu verwenden. Dieser Bolzen kann verstemmt werden. Der verstemmte Bereich des Bolzens bildet sodann den Kopf. In einer weiteren Alternative kann als Befestigungselement eine Niet eingesetzt werden. Auch dabei wird ein Kopf ausgebildet. Erfindungsgemäß ist vorgesehen, dass der Kopf des Befestigungselements lediglich auf der Hülse und nicht etwa auf der Leiterplatte aufliegt. Des Weiteren ist an der der Basis zugewandten Seite der Hülse ein erster Überstand ausgebildet. Dieser erste Überstand beabstandet die Leiterplatte von der Basis. Aufgrund dessen, dass der Kopf lediglich die Hülse berührt und gleichzeitig der erste Überstand angeordnet ist, erfolgt die Krafteinleitung des Befestigungselementes lediglich in die Hülse und nicht direkt in die Leiterplatte. Die kraftschlüssige Verbindung zwischen Hülse und Basis ist somit völlig unabhängig von den physikalischen Eigenschaften der Leiterplatte, insbesondere von dem Setzverhalten der Leiterplatte. Der Strom fließt von der Leiterplatte in die Hülse und von der Hülse in die Basis und/oder von der Hülse über das Befestigungselement in die Basis. Selbstverständlich können an einer Leiterplatte mehrere Befestigungslöcher mit entsprechend mehreren Hülsen und mehreren Befestigungselementen angeordnet werden.

Die Unteransprüche zeigen bevorzugte Weiterbildungen der Erfindung.

Wie soeben beschrieben, darf die Krafteinleitung vom Kopf lediglich in die Hülse und nicht in die Leiterplatte erfolgen. Hierzu gibt es zwei bevorzugte Varianten, die auch untereinander kombiniert werden können: Gemäß der erste Variante ist vorgesehen, dass ein Außendurchmesser der Hülse an der dem Kopf zugewandten Seite größer ist als ein Kopfdurchmesser des Kopfes. Wie beschrieben, kann der Kopf unterschiedlich gestaltet werden. Selbst eine Beilag-oder Unterlegscheibe muss im Sinne der Erfindung zum Kopf gerechnet werden, so dass der größte, auf der Hülse aufliegende Durchmesser des Kopfes als "Kopfdurchmesser" definiert ist. Durch diese entsprechend große Ausgestaltung der Hülse liegt der Kopf lediglich auf der Hülse und nicht etwa auf der Leiterplatte auf. Gemäß der zweiten Variante ist vorgesehen, dass die Hülse an der dem Kopf zugewandten Seite mit einem zweiten Überstand über die Leiterplatte übersteht. Durch diesen zweiten Überstand wird sichergestellt, dass der Kopf lediglich auf der Hülse aufliegt und dabei die Leiterplatte nicht berührt. Dabei ist vorteilhafterweise vorgesehen, dass der zweite Überstand zumindest 150 µm, besonders bevorzugt zumindest 300 µm, beträgt. Durch diesen ausreichend großen zweiten Überstand kann die Hülse beim Anziehen des Befestigungselementes entsprechend deformiert werden, ohne dass ein Kontakt zwischen Kopf und Leiterplatte erfolgt.

Vorteilhafterweise ist ein Innendurchmesser des Befestigungsloches größer als ein Außendurchmesser der Hülse. Der dadurch entstehende Zwischenraum wird vorzugsweise zumindest teilweise mit Lot gefüllt. Dadurch entsteht eine relativ massive Lotverbindung zwischen Hülse und Leiterplatte.

Des Weiteren ist bevorzugt vorgesehen, dass die Leiterplatte in dem Befestigungsloch durchkontaktiert ist. Unter "durchkontaktiert" versteht man, dass zumindest zwei Lagen der Leiterplatte miteinander elektrisch leitend verbunden sind.

Ferner ist vorgesehen, dass der erste Uberstand als Kragen der Hülse ausgebildet ist. Zwischen der Leiterplatte und der Basis befindet sich somit ein Kragen, der insbesondere einstückiger Bestandteil der gesamten Hülse ist. Die Leiterplatte liegt auf einer Seite des Kragens auf. Die gegenüberliegende Seite des Kragens liegt auf der Basis auf. Der Kragen bietet ausreichend Fläche zur elektrisch leitenden Verbindung zwischen Hülse und Basis.

Weiter ist dabei vorgesehen, dass der Kragen mit der Leiterplatte verlötet ist.

Des Weiteren ist zumindest ein Zusatzloch in der Leiterplatte vorgesehen. Das zumindest eine Zusatzloch erstreckt sich dabei vorteilhafterweise parallel zum Befestigungsloch. Das zumindest eine Zusatzloch führt bis zum Kragen und ist zumindest teilweise mit Lot gefüllt. So erstreckt sich das Lot nicht nur in einen Spalt zwischen Leiterplatte und Kragen, sondern auch in das zumindest eine Zusatzloch. Vorteilhafterweise wird eine Vielzahl an Zusatzlöchern rund um das Befestigungsloch angeordnet. Besonders bevorzugt werden hierbei zumindest fünf Zusatzlöcher verwendet. Ein Durchmesser des einzelnen Zusatzloches ist vorteilhafterweise wesentlich kleiner als ein Durchmesser des Befestigungsloches. Insbesondere beträgt ein Durchmesser des Zusatzloches höchstens 25% eines Durchmessers des Befestigungsloches. Dadurch bleibt die Leiterplatte ausreichend stabil.

Die Erfindung umfasst des Weiteren eine Leistungselektronik. Die Leistungselektronik wird insbesondere in einem Fahrzeug angewandt. Die Leistungselektronik umfasst zumindest eine Kontaktanordnung, wie sie soeben beschrieben wurde. Die im Rahmen der erfindungsgemäßen Kontaktanordnung beschriebenen vorteilhaften Ausgestaltungen und Unteransprüche finden entsprechend vorteilhafte Anwendung für die Leistungselektronik. Besonders bevorzugt handelt es sich dabei um eine Leistungselektronik für ein Elektro- oder Hybrid-Fahrzeug. Die Kontaktanordnung wird vorteilhafterweise zur Kontaktierung eines DC/DC-Wandlers, eines Batteriemanagementsystems oder einer Lenkung angewandt. Ferner kann die Kontaktanordnung z.B. auch bei Industrieelektronik verwendet werden.

### Kurze Beschreibung der Zeichnungen

Nachfolgend werden Ausführungsbeispiele der Erfindung unter Bezugnahme auf die begleitende Zeichnung im Detail beschrieben. In der Zeichnung ist:
- Figur 1: eine Schnittansicht einer erfindungsgemäßen Kontaktanordnung gemäß einem ersten Ausführungsbeispiel,
- Figur 2: eine Schnittansicht einer erfindungsgemäßen Kontaktanordnung gemäß einem zweiten Ausführungsbeispiel, und
- Figur 3: eine isometrische Ansicht einer erfindungsgemäßen Kontaktanordnung gemäß einem dritten Ausführungsbeispiel.

### Ausführungsformen der Erfindung

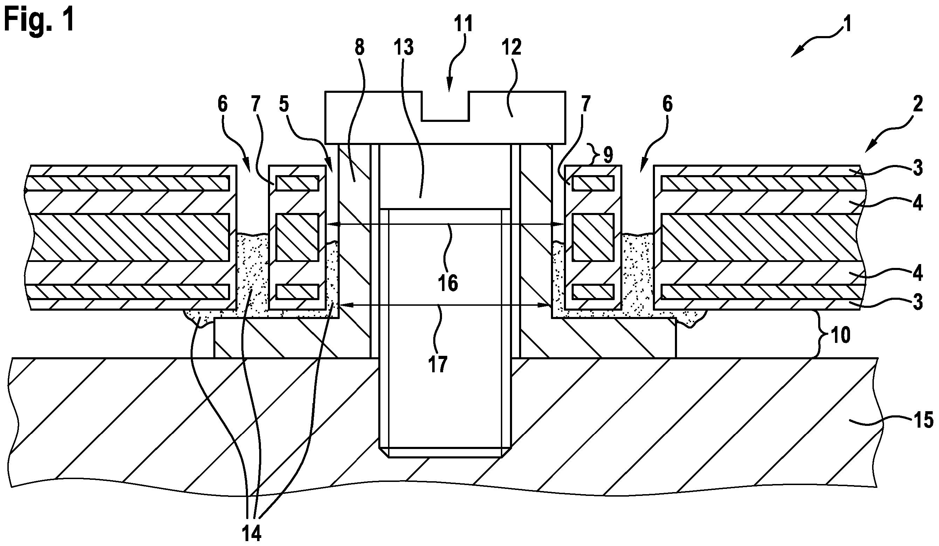

Nachfolgend werden drei Ausführungsbeispiele einer Kontaktanordnung 1 anhand der Figuren 1 bis 3 beschrieben. Gleiche bzw. funktional gleiche Bauteile sind in allen Ausführungsbeispielen mit denselben Bezugszeichen versehen.

Gemäß Figur 1 umfasst die Kontaktanordnung 1 eine Leiterplatte 2. Diese Leiterplatte 2 wird mittels der Kontaktanordnung 1 mit einer Basis 15 elektrisch leitend kontaktiert und gleichzeitig kraftschlüssig mit der Basis 15 verbunden. Dargestellt ist lediglich eine Verbindungsstelle. Allerdings können auch mehrere gleichbauende Kontaktanordnungen 1 zwischen Leiterplatte 2 und Basis 15 verwendet werden.

Die Leiterplatte 2 umfasst zwei Außenlagen 3 und mehrere Innenlagen 4. Die unterschiedlichen Lagen 3, 4 sind durch ein entsprechendes Substrat voneinander isoliert. In der Leiterplatte 2 ist ein Befestigungsloch 5 in Form eines Durchgangsloches ausgebildet. Rund um das Befestigungsloch 5 sind mehrere kleine Zusatzlöcher 6 ausgebildet. Auch die Zusatzlöcher 6 sind als Durchgangslöcher ausgebildet. Im ersten Ausführungsbeispiel sind das Befestigungsloch 5 und die Zusatzlöcher 6 durchkontaktiert. Hierzu ist jeweils eine Durchkontaktierung 7 vorgesehen, die die einzelnen Lagen 3, 4 miteinander elektrisch leitend verbindet.

In das Befestigungsloch 5 ist eine Hülse 8 aus Metall eingesetzt. Die Hülse 8 weist an ihrer der Basis 15 zugewandten Seite einen ersten Überstand 10 auf. Dieser erste Überstand 10 ist als Kragen ausgebildet. Dieser Kragen hat einen entsprechend großen Durchmesser, so dass er bis über die Zusatzlöcher 6 reicht.

In der Hülse 8 steckt ein Befestigungselement 11. Das Befestigungselement 11 umfasst einen Schaft 13. Der Schaft 13 ist fest mit der Basis verbunden. Im gezeigten Ausführungsbeispiel ist der Schaft 13 mit der Basis 15 verschraubt. Am anderen Ende des Schaftes 13 ist ein Kopf 12 ausgebildet. An der dem Kopf 12 zugewandten Seite weist die Hülse 8 einen zweiten Überstand 9 auf. Die Hülse 8 steht somit beidseitig über die Leiterplatte 2 über. Aufgrund des zweiten Überstandes 9 berührt der Kopf 12 lediglich die Hülse 8 und nicht die Leiterplatte 2. Somit erfolgt eine direkte und ausschließliche Krafteinleitung über das Befestigungselement 11 in die Hülse 8 und nicht etwa in die Leiterplatte 2.

Zur mechanischen und elektrisch leitenden Verbindung zwischen der Leiterplatte 2 und der Hülse 8 ist ein Lot 14 vorgesehen: Das Befestigungsloch 5 weist einen Innendurchmesser 16 auf. Ein Außendurchmesser 17 der Hülse ist kleiner als der Innendurchmesser 16, so dass ein Freiraum verbleibt. Dieser Freiraum ist mit dem Lot 14 gefüllt. Des Weiteren befindet sich das Lot 14 zwischen dem Kragen der Hülse 8 und der Unterseite der Leiterplatte 2. Darüber hinaus sind die Zusatzlöcher 6 zumindest teilweise mit Lot 14 gefüllt.

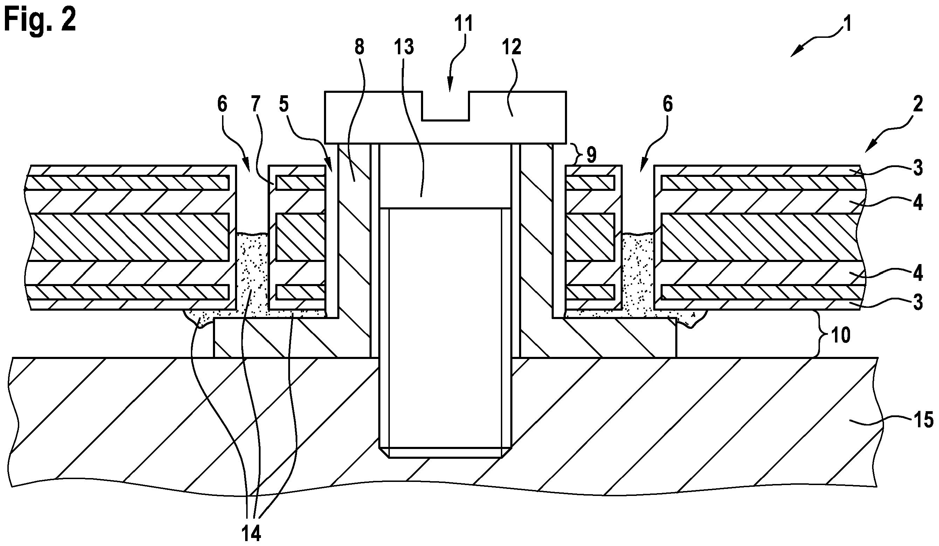

Figur 2 zeigt die Kontaktanordnung 1 gemäß dem zweiten Ausführungsbeispiel. Das zweite Ausführungsbeispiel entspricht weitestgehend dem ersten Ausführungsbeispiel. Allerdings ist die Leiterplatte 2 im zweiten Ausführungsbeispiel innerhalb des Befestigungsloches 5 nicht durchkontaktiert. Dementsprechend kann unter Umständen auf das Lot 14 im Befestigungsloch 5 verzichtet werden. Nichtsdestotrotz erfolgt eine ausreichend mechanische und elektrische Verbindung über das Lot 14 in den Zusatzlöchern 6 und/oder im Spalt zwischen der Unterseite der Leiterplatte 2 und dem Kragen der Hülse 8.

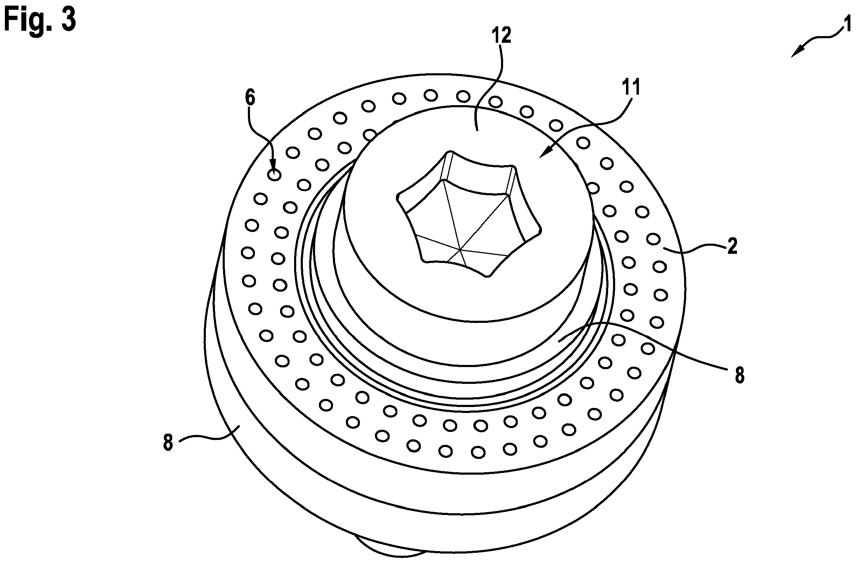

Figur 3 zeigt in isometrischer Ansicht die Kontaktanordnung 1 gemäß dem dritten Ausführungsbeispiel. Im dritten Ausführungsbeispiel muss die Hülse 8 nicht zwingend einen zweiten Überstand 9 aufweisen, da hier ein Kopfdurchmesser des Kopfes 12 kleiner ist als ein Außendurchmesser der Hülse an der dem Kopf zugewandten Seite. Dadurch steht auch unabhängig vom zweiten Überstand 9 der Kopf lediglich in Kontakt mit der Hülse 8 und nicht mit der Leiterplatte 2.

Die drei Ausführungsbeispiele zeigen als Befestigungselement eine Schraube. Der Kopf 12 ist dabei gebildet durch den Schraubenkopf. Alternativ könnte der Kopf 12 auch gebildet sein durch eine Mutter, die auf ein Gewinde des Schafts 13 aufgeschraubt ist. Anstatt einer Schraube kann das Befestigungselement 11 ein fest mit der Basis 15 verbundener Bolzen sein. Dieser Bolzen kann zur Ausbildung des Kopfes verstemmt werden. Des Weiteren kann das Befestigungselement 11 als Niet ausgebildet werden. In all diesen Varianten gibt es eine Art Kopf 12, der bei entsprechender Ausbildung der Hülse 8 lediglich auf die Hülse 8 wirkt und nicht in Berührung steht mit der Leiterplatte 2.

## Patentansprüche

1. Kontaktanordnung (1), vorzugsweise für eine Leistungselektronik, umfassend
- eine Leiterplatte (2) mit einem Befestigungsloch (5),
- eine in das Befestigungsloch (5) eingesetzte Hülse (8) aus Metall, wobei die Hülse (8) mit der Leiterplatte (2) verlötet ist,
- eine Basis (15) auf der die Hülse (8) zur elektrischen Kontaktierung aufliegt, und
- ein durch die Hülse (8) ragendes Befestigungselement (11), wobei ein Ende des Befestigungselementes (11) fest mit der Basis (15) verbunden ist und am anderen Ende ein Kopf (12) ausgebildet oder angeordnet ist,
- wobei der Kopf (12) des Befestigungselementes (11) lediglich auf der Hülse (8) und nicht auf der Leiterplatte (2) aufliegt, und
- wobei die Hülse (8) an der der Basis (15) zugewandten Seite mit einem ersten Überstand (10) über die Leiterplatte (2) übersteht, wobei der erste Überstand die Leiterplatte (2) von der Basis (15) beabstandet, **dadurch gekennzeichnet, dass** der erste Überstand (10) als Kragen der Hülse (8) ausgebildet ist, wobei die Leiterplatte (2) auf einer Seite des Kragens aufliegt und die gegenüberliegende Seite des Kragens auf der Basis (15) aufliegt, wobei der Kragen mit der Leiterplatte (2) verlötet ist, wobei zumindest ein Zusatzloch (6) in der Leiterplatte (2) vorgesehen ist, wobei das zumindest eine Zusatzloch (6) bis zum Kragen führt und zumindest teilweise mit Lot gefüllt ist.

2. Kontaktanordnung (1) nach Anspruch 1, **dadurch gekennzeichnet, dass** ein Außendurchmesser (17) der Hülse (8) an der dem Kopf (12) zugewandten Seite größer ist als ein Kopfdurchmesser des Kopfes (12) und/oder dass die Hülse (8) an der dem Kopf (12) zugewandten Seite mit einem zweiten Überstand über die Leiterplatte (2) übersteht.

3. Kontaktanordnung (1) nach einem der vorhergehenden Ansprüche, **dadurch gekennzeichnet, dass** ein Innendurchmesser (16) des Befestigungsloches (5) größer ist als ein Außendurchmesser (17) der Hülse (8), wobei der Raum zwischen Hülse (8) und Befestigungsloch (5) zumindest teilweise mit Lot (14) gefüllt ist.

4. Kontaktanordnung (1) nach einem der vorhergehenden Ansprüche, **dadurch gekennzeichnet, dass** die Leiterplatte (2) in dem Befestigungsloch (5) durchkontaktiert ist.

5. Kontaktanordnung (1) nach einem der vorhergehenden Ansprüche, **dadurch gekennzeichnet, dass** die Leiterplatte (2) in dem zumindest einem Zusatzloch (6) durchkontaktiert ist.

6. Kontaktanordnung (1) nach einem der vorhergehenden Ansprüche, **dadurch gekennzeichnet, dass** das Befestigungselement (11) eine Schraube, eine Niet oder ein verstemmter Bolzen ist.

7. Leistungselektronik, vorzugsweise für ein Fahrzeug, umfassend zumindest eine Kontaktanordnung (1) nach einem der vorhergehenden Ansprüche.

## Claims

1. Contact arrangement (1), preferably for a power electronics system, comprising
- a printed circuit board (2) with a fastening hole (5),
- a sleeve (8) composed of metal which is inserted into the fastening hole (5), wherein the sleeve (8) is soldered to the printed circuit board (2),
- a base (15) on which the sleeve (8) rests for the purpose of making electrical contact, and
- a fastening element (11) which protrudes through the sleeve (8), wherein one end of the fastening element (11) is fixedly connected to the base (15) and a head (12) is formed or arranged at the other end,
- wherein the head (12) of the fastening element (11) rests only on the sleeve (8) and not on the printed circuit board (2), and
- wherein the sleeve (8), on that side which faces the base (15), projects beyond the printed circuit board (2) by way of a first projection (10), wherein the first projection spaces apart the printed circuit board (2) from the base (15), **characterized in that** the first projection (10) is designed as a collar of the sleeve (8), wherein the printed circuit board (2) rests on one side of the collar and the opposite side of the collar rests on the base (15), wherein the collar is soldered to the printed circuit board (2), wherein at least one additional hole (6) is provided in the printed circuit board (2), wherein the at least one additional hole (6) leads as far as the collar and is at least partially filled with solder.

2. Contact arrangement (1) according to Claim 1, **characterized in that** an outside diameter (17) of the sleeve (8), on that side which faces the head (12), is greater than a head diameter of the head (12), and/or **in that** the sleeve (8), on that side which faces the head (12), projects beyond the printed circuit board (2) by way of a second projection.

3. Contact arrangement (1) according to either of the preceding claims, **characterized in that** an inside diameter (16) of the fastening hole (5) is greater than an outside diameter (17) of the sleeve (8), wherein the space between the sleeve (8) and the fastening hole (5) is at least partially filled with solder (14).

4. Contact arrangement (1) according to one of the preceding claims, **characterized in that** the printed circuit board (2) is through-plated in the fastening hole (5) .

5. Contact arrangement (1) according to one of the preceding claims, **characterized in that** the printed circuit board (2) is through-plated in the at least one additional hole (6).

6. Contact arrangement (1) according to one of the preceding claims, **characterized in that** the fastening element (11) is a screw, a rivet or a caulked bolt.

7. Power electronics system, preferably for a vehicle, comprising at least one contact arrangement (1) according to one of the preceding claims.

## Revendications

1. Ensemble de contacts (1), de préférence pour un dispositif électronique de puissance, comprenant
- une carte de circuits (2) dotée d'un trou de fixation (5),
- une douille métallique (8) insérée dans le trou de fixation (5), la douille (8) étant reliée par brasage à la carte de circuits (2),
- une base (15) sur laquelle repose la douille (8) pour la mise en contact électrique, et
- un élément de fixation (11) faisant saillie à travers la douille (8), une extrémité de l'élément de fixation (11) étant reliée solidement à la base (15), et une tête (12) étant réalisée ou disposée à l'autre extrémité,
- dans lequel la tête (12) du dispositif de fixation (11) ne repose que sur la douille (8) et non pas sur la carte de circuits (2), et
- dans lequel, sur le côté tourné vers la base (15), la douille (8) dépasse d'une première projection (10) de la carte de circuits (2), la première projection espaçant la carte de circuits (2) par rapport à la base (15),
**caractérisé en ce que** la première projection (10) est réalisée sous la forme d'une collerette de la douille (8), la carte de circuits (2) reposant sur un côté de la collerette et le côté opposé de la collerette reposant sur la base (15), la collerette étant reliée par brasage à la carte de circuits (2), au moins un trou supplémentaire (6) étant prévu dans la carte de circuits (2), ledit au moins un trou supplémentaire (6) allant jusqu'à la collerette et étant rempli de métal de brasage au moins en partie.

2. Ensemble de contacts (1) selon la revendication 1, **caractérisé en ce qu'**un diamètre extérieur (17) de la douille (8) est supérieur sur le côté tourné vers la tête (12) à un diamètre de tête de la tête (12) et/ou **en ce que** la douille (8) dépasse d'une deuxième projection de la carte de circuits (2) sur le côté tourné vers la tête (12).

3. Ensemble de contacts (1) selon l'une quelconque des revendications précédentes, **caractérisé en ce qu'**un diamètre intérieur (16) du trou de fixation (5) est supérieur à un diamètre extérieur (17) de la douille (8), l'espace entre la douille (8) et le trou de fixation (5) étant rempli de métal de brasage (14) au moins en partie.

4. Ensemble de contacts (1) selon l'une quelconque des revendications précédentes, **caractérisé en ce que** la carte de circuits (2) est métallisée dans le trou de fixation (5).

5. Ensemble de contacts (1) selon l'une quelconque des revendications précédentes, **caractérisé en ce que** la carte de circuits (2) est métallisée dans ledit au moins un trou supplémentaire (6).

6. Ensemble de contacts (1) selon l'une quelconque des revendications précédentes, **caractérisé en ce que** l'élément de fixation (11) est une vis, un rivet ou un boulon maté.

7. Dispositif électronique de puissance, de préférence pour un véhicule, comprenant au moins un ensemble de contacts (1) selon l'une quelconque des revendications précédentes.
